# EUROPEAN PATENT APPLICATION

(11) **EP 4 704 518 A1**
(43) Date of publication of application: **04.03.2026**
(21) Application number: 25186106.8
(22) Date of filing: 30.06.2025
(51) Int. Cl.: H10D 62/10, H10D 30/01, H10D 30/43, H10D 30/00, H10D 84/83

(54) **EPITAXIAL SOURCE AND DRAIN REGIONS WITH LOW-K INNER SPACERS**

(30) Priority: 26.08.2024 US 202418814799
(71) Applicant: INTEL Corporation, Santa Clara, CA 95054 (US)
(72) Inventor: Li, Xia, San Diego CA 92130 (US); Naskar, Sudipto, Portland OR 97229 (US); Huang, Chun-Kuo, Portland OR 97229 (US); Joiner, Corey, Beaverton OR 97006 (US); Huang, Wen-Hsi, Hillsboro OR 97124 (US)
(74) Representative: Samson & Partner Patentanwälte mbB

(57) **Abstract**

Techniques are provided herein to form an integrated circuit having semiconductor devices with low-k inner dielectric spacers between semiconductor bodies (e.g., nanoribbons, nanowires, or nanosheets). The dielectric spacers may include any suitable low-k dielectric material. Additionally, the inner dielectric spacers may be formed after the formation of source or drain regions, which improves the stress profile of the source or drain regions against the semiconductor bodies. In one such example, semiconductor bodies extend in a first direction between source or drain regions and a gate structure extends in a second direction over the semiconductor bodies between the source or drain regions. Inner spacers separate the gate structure from the source or drain regions along the first direction. The inner spacers may include a low-k dielectric material, such as silicon dioxide. In some examples, the inner spacers extend outwards beyond the ends of the semiconductor bodies along the first direction.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. The use of certain materials may be advantageous for some fabrication processes, but detrimental to the overall device performance. Accordingly, there remain a number of non-trivial challenges with respect to forming such high-density semiconductor devices.

### BRIEF DESCRIPTION OF THE DRAWINGS

Figures 1A and 1B are cross-sectional views of semiconductor devices in an integrated circuit that include low-k inner spacers, in accordance with an embodiment of the present disclosure.
Figures 2A and 2B are cross-sectional views that illustrate one stage in an example process for forming an integrated circuit having semiconductor devices with low-k inner spacers, in accordance with an embodiment of the present disclosure.
Figures 3A and 3B are cross-sectional views that illustrate another stage in the example process for forming an integrated circuit having semiconductor devices with low-k inner spacers, in accordance with an embodiment of the present disclosure.
Figures 4A and 4B are cross-sectional views that illustrate another stage in the example process for forming an integrated circuit having semiconductor devices with low-k inner spacers, in accordance with an embodiment of the present disclosure.
Figures 5A and 5B are cross-sectional views that illustrate another stage in the example process for forming an integrated circuit having semiconductor devices with low-k inner spacers, in accordance with an embodiment of the present disclosure.
Figures 6A and 6B are cross-sectional views that illustrate another stage in the example process for forming an integrated circuit having semiconductor devices with low-k inner spacers, in accordance with an embodiment of the present disclosure.
Figures 7A and 7B are cross-sectional views that illustrate another stage in the example process for forming an integrated circuit having semiconductor devices with low-k inner spacers, in accordance with an embodiment of the present disclosure.
Figures 8A and 8B are cross-sectional views that illustrate another stage in the example process for forming an integrated circuit having semiconductor devices with low-k inner spacers, in accordance with an embodiment of the present disclosure.
Figures 9A and 9B are cross-sectional views that illustrate another stage in the example process for forming an integrated circuit having semiconductor devices with low-k inner spacers, in accordance with an embodiment of the present disclosure.
Figures 10A and 10B are cross-sectional views that illustrate another stage in the example process for forming an integrated circuit having semiconductor devices with low-k inner spacers, in accordance with an embodiment of the present disclosure.
Figures 11A and 11B are cross-sectional views that illustrate another stage in the example process for forming an integrated circuit having semiconductor devices with low-k inner spacers, in accordance with an embodiment of the present disclosure.
Figures 12A and 12B are cross-sectional views that illustrate another stage in the example process for forming an integrated circuit having semiconductor devices with low-k inner spacers, in accordance with an embodiment of the present disclosure.
Figures 13A and 13B are cross-sectional views that illustrate a stage in another example process for forming an integrated circuit having semiconductor devices with low-k inner spacers, in accordance with an embodiment of the present disclosure.
Figure 14 illustrates a cross-sectional view of a chip package containing one or more semiconductor dies, in accordance with some embodiments of the present disclosure.
Figure 15 is a flowchart of a fabrication process for an integrated circuit having semiconductor devices with low-k inner spacers, in accordance with an embodiment of the present disclosure.
Figure 16 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having semiconductor devices with low-k inner dielectric spacers between nanoribbons (or nanowires or nanosheets, depending on process node and transistor structure). The dielectric spacers may include any suitable low-k dielectric material (e.g., a material having a dielectric constant equal to or lower than that of silicon dioxide. Additionally, the inner dielectric spacers may be formed after the formation of source or drain regions, which improves the stress profile of the source or drain regions against the semiconductor nanoribbons. The techniques can be used separately or in combination on the same die, and in any number of integrated circuit applications and are particularly useful with respect to logic and memory cells, such as those cells that use gate-all-around transistors (e.g., ribbonFETs and nanowire FETs) or forksheet transistors. In one such example, semiconductor nanoribbons extend in a first direction between source or drain regions and a gate structure extends in a second direction over the semiconductor nanoribbons between the source or drain regions. Inner spacers separate the gate structure from the source or drain regions along the first direction. The inner spacers may include a low-k dielectric material, such as silicon dioxide. In some examples, the inner spacers extend outwards beyond the ends of the nanoribbons along the first direction. Numerous variations and embodiments will be apparent in light of this disclosure.

### General Overview

As previously noted above, there remain a number of non-trivial challenges with respect to integrated circuit fabrication. In more detail, gate-all-around (GAA) or forksheet devices are useful as they provide a large transistor channel surface (e.g., around the outside surface of each nanoribbon) in a relatively small footprint. However, the fabrication of such devices is more complicated and some of the features can have a detrimental effect on the performance. For example, dielectric spacers are used between the channel bodies (e.g., nanowires, nanoribbons or nanosheets) to separate the gate structure from the source or drain regions. Such spacers are often formed with high-k materials (e.g., silicon nitride) for protection against subsequent fabrication processes. But the high-k materials cause an increase in the parasitic capacitance which can degrade the transistor performance. Additionally, the source or drain regions are epitaxially grown from the relatively short ends of the nanoribbons instead of along a relatively larger surface area of semiconductor material. This can result in a weak stress profile along the nanoribbons and a lower carrier mobility.

Thus, and in accordance with an embodiment of the present disclosure, techniques are provided herein to form ribbonized semiconductor devices (e.g., GAA and forksheet), having inner spacers with a low-k dielectric material. Additionally, the source or drain regions are formed before the formation of the inner spacers, which allows the source or drain regions to be grown along a continuous and relatively larger semiconductor surface. As a result, the source or drain regions exert a greater stress (tensile or compressive) on the channel bodies (e.g., nanoribbons, nanowires, or nanosheets). According to an embodiment, one or more NMOS devices are formed with first nanoribbons extending between n-type source or drain regions and a first gate structure extending over the first nanoribbons along a second direction. First inner spacers between the first gate structure and the n-type source or drain regions along the first direction have a low-k dielectric material, such as silicon dioxide, or any other dielectric material having a dielectric constant of less than 3.9. According to an embodiment, one or more PMOS GAA devices are formed with second nanoribbons extending between p-type source or drain regions and a second gate structure extending over the second nanoribbons along a second direction. Second inner spacers between the second gate structure and the p-type source or drain regions along the first direction have a low-k dielectric material, such as silicon dioxide, or any other dielectric material having a dielectric constant of less than 3.9. Furthermore, the second inner spacers may extend beyond the ends of the second nanoribbons (and into the p-type source or drain regions) along the first direction due to the fabrication process as is further described in more detail below. Both the NMOS devices and PMOS devices may be formed on the same substrate, such as on the same die, and even adjacent to one another along the second direction in some cases.

According to an embodiment, an integrated circuit includes a semiconductor device having one or more semiconductor bodies (e.g., nanoribbons) extending in a first direction from a source or drain region and a gate structure extending in a second direction over the one or more semiconductor bodies, and dielectric spacers adjacent to ends of the semiconductor bodies. The dielectric spacers are between the gate structure and the source or drain region along the first direction. The dielectric spacers laterally protrude beyond the ends of the semiconductor bodies along the first direction and into the source or drain region.

According to another embodiment, an electronic device includes a chip package having one or more dies. At least one of the one or more dies includes one or more semiconductor bodies (e.g., nanoribbons) extending in a first direction from a first source or drain region to a second source or drain region, a gate structure extending in a second direction over the one or more semiconductor bodies, first dielectric spacers adjacent to first ends of the semiconductor bodies, and second dielectric spacers adjacent to second ends of the semiconductor bodies. The first dielectric spacers are between the gate structure and the first source or drain region along the first direction and the second dielectric spacers are between the gate structure and the second source or drain region along the first direction. The first dielectric spacers laterally protrude beyond the first ends of the semiconductor bodies along the first direction and the second dielectric spacers laterally protrude beyond the second ends of the semiconductor nanoribbons along the second direction. In this manner, the first and second dielectric spacers may extend into the first and second source or drain regions, respectively.

According to another embodiment, an integrated circuit includes a first semiconductor device having one or more first semiconductor bodies (e.g., nanoribbons) extending in a first direction from a first source or drain region and a first gate structure extending in a second direction over the one or more first semiconductor bodies, a second semiconductor device having one or more second semiconductor bodies (e.g., nanoribbons) extending in the first direction from a second source or drain region and a second gate structure extending in the second direction over the one or more second semiconductor bodies, first dielectric spacers adjacent to ends of the first semiconductor bodies, and second dielectric spacers adjacent to ends of the second semiconductor bodies. The first dielectric spacers are between the first gate structure and the first source or drain region along the first direction and the second dielectric spacers are between the second gate structure and the second source or drain region along the second direction. The first dielectric spacers laterally protrude beyond the ends of the first semiconductor bodies along the first direction. In this manner, the first and second dielectric spacers may extend into the first and second source or drain regions, respectively.

According to an embodiment, a method of forming an integrated circuit includes: forming a fin comprising layers of first semiconductor material alternating with layers of second semiconductor material, the fin extending above a substrate and extending lengthwise along a first direction; forming a sacrificial gate extending over the fin along a second direction and forming spacer structures on sidewalls of the sacrificial gate; removing a portion of the fin not protected by the sacrificial gate and sidewall structures such that ends of the layers of first semiconductor material alternating with layers of second semiconductor material are exposed; forming a source or drain region at the exposed ends of the layers of first semiconductor material and layers of second semiconductor material; removing the sacrificial gate; removing the layers of second semiconductor material thus exposing portions of the source or drain region; etching the exposed portions of the source or drain region to form lateral cavities; forming a dielectric material within the lateral cavities and adjacent to the ends of the layers of first semiconductor material; and forming a gate structure around the layers of first semiconductor material and on the dielectric material.

The techniques can be used with any type of non-planar transistors, including nanowire and nanoribbon transistors (sometimes called gate-all-around transistors) or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the extension of the inner spacers beyond the ends of the channel bodies (e.g., nanoribbons (e.g., into the source or drain regions), for certain devices. In some example embodiments, XRD or EDX analysis may be performed to confirm the low-k dielectric material of the inner spacers.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

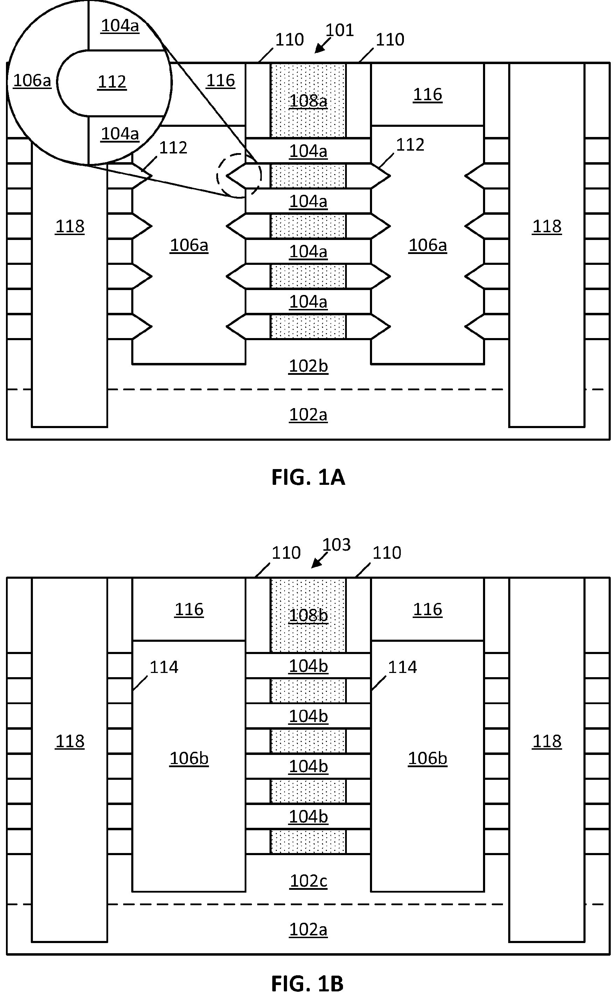

Figure 1A is a cross-section view taken through a first semiconductor device 101 along a 'fin' direction that illustrates the semiconductor bodies extending between source or drain regions of first semiconductor device 101, in accordance with an embodiment of the present disclosure. Figure 1B illustrates a cross-section view taken through a second semiconductor device 103 on the same die as first semiconductor device 101. Second semiconductor device 103 may be further along the same fin as first semiconductor device 101, or may be part of a different fin extending parallel to the fin of first semiconductor device 101. As used herein, the term 'fin' can refer to the original fin-shaped semiconductor structure from which nanoribbons, nanowires, or nanosheets are formed. Each of the semiconductor devices may be, for instance, non-planar metal oxide semiconductor (MOS) transistors, such gate-all-around (GAA) transistors, although other transistor topologies and types could also benefit from the techniques provided herein, such as forksheet transistors (which would be similar to that shown in the figures, except that only one side of the dielectric "spine" is shown). The examples herein illustrate semiconductor devices with a transistor structure having a ribbonized channel region (e.g., generally meaning a channel region having one or more nanoribbons, nanowires, or nanosheets that extend between source and drain regions). In some such examples, the integrated circuit being formed may have, for instance, a p-type GAA device adjacent to an n-type GAA device, or a forksheet structure having a p-type device and an n-type device separated by a dielectric spine or structure.

The semiconductor material used in each of the semiconductor devices may be formed from or on a semiconductor substrate. According to some embodiments, the substrate is removed following the completion of all topside processing and is replaced with a base dielectric structure. The base dielectric structure may represent any number of dielectric layers and/or materials.

According to some embodiments, the substrate may include a bulk portion 102a, a first doped well 102b, and a second doped well 102c. Bulk portion 102a may be a lightly doped semiconductor, such as a silicon substrate with p-type dopants (e.g., boron) or n-type dopants (e.g., phosphorous). First doped well 102b may be a top layer or portion of the substrate with a heavier dopant concentration (either n or p) depending on the type of transistor, while second doped well 102c is a similar top layer or portion of the substrate with a heavier dopant concentration (either n or p). According to an embodiment, first semiconductor device 101 is a p-channel device and first doped well 102b includes a high concentration of n-type dopants (e.g., phosphorous or arsenic), and second semiconductor device 103 is a n-channel device and second doped well 102c includes a high concentration of p-type dopants (e.g., boron). Each of first doped well 102b and second doped well 102c may have a thickness, for example, between 10 nm to 30 nm, although other thicknesses may be used.

The one or more semiconductor regions of the devices may include fins of alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. The alternating layers can be blanket deposited and then etched into fins or deposited into fin-shaped trenches, in some examples.

First semiconductor device 101 includes one or more semiconductor regions (also called channel regions or channel bodies), such as one or more nanoribbons 104a extending between epitaxial first source or drain regions 106a in the first direction. Similarly, second semiconductor device 103 includes one or more semiconductor nanoribbons 104b extending between epitaxial second source or drain regions 106b in the first direction. First gate structure 108a extends over nanoribbons 104a of first semiconductor device 101 in a second direction (e.g., into and out of the page) to form the transistor gate of first semiconductor device 101 and second gate structure 108b extends over nanoribbons 104b of second semiconductor device 103 in the second direction to form the transistor gate of second semiconductor device 103.

Any of source or drain regions 106a/106b may act as either a source region or a drain region, depending on the application and dopant profile. Any semiconductor materials suitable for source and drain regions can be used (e.g., group IV and group III-V semiconductor materials) for any of the illustrated source or drains regions 106a/106b. In any such cases, the composition and doping of source or drain regions 106a and 106b may be the same or different, depending on the polarity of the transistors. In an example, first semiconductor device 101 is a p-channel device, and first source or drain regions 106a include silicon germanium having a high concentration of p-type dopants. Additionally, second semiconductor device 103 may be an n-channel device, and second source or drain regions 106b include silicon having a high concentration of n-type dopants. Any number of source and drain configurations and materials can be used. Note that source or drain regions 106a/106b may extend into a portion of respective first doped well 102b and second doped well 102c, which includes the opposite dopant type from source or drain regions 106a/106b to reduce leakage.

The gate structures 108a/108b may each include a gate electrode that is made up of a conductive fill and one or more metal workfunction layers, according to some embodiments. The gate structures 108a/108b also include a gate dielectric that may represent any number of dielectric layers. The conductive fill may include any sufficiently conductive material such as a metal, metal alloy, or doped polysilicon. In some examples, the conductive fill includes tungsten (W), although other metals or conductive materials may be used, such as aluminum (Al), molybdenum (Mo), ruthenium (Ru), cobalt (Co), or doped polysilicon. As noted above, first semiconductor device 101 may be a p-channel device having a first gate structure 108a with one or more workfunction layers of molybdenum nitride (MoN). Other metal workfunction layers of p-channel devices can include tantalum nitride (TaN) and titanium nitride (TiN). Furthermore, second semiconductor device 103 may be an n-channel device having a second gate structure 108b with one or more workfunction layers of tungsten. Other metal workfunction layers of n-channel devices can include tantalum nitride (TaN) or titanium nitride (TiN).

The gate dielectric of each gate structure 108a/108b may include any suitable gate dielectric material(s). In some embodiments, the gate dielectric includes a layer of native oxide material (e.g., silicon dioxide germanium dioxide, or SiGe oxide) on nanoribbons 104a/104b, and a layer of high-k dielectric material (e.g., hafnium oxide or aluminum oxide) on the native oxide. According to some embodiments, spacer structures 110 are present along the sidewalls of gate structures 108a/108b. Spacer structures 110 may be any suitable dielectric material, such as silicon nitride, and may define the gate trench within which gate structures 108a/108b are formed.

According to some embodiments, first semiconductor device 101 includes first inner spacers 112 between first gate structure 108a and first source or drain regions 106a along the first direction, and second semiconductor device 103 includes second inner spacers 114 between second gate structure 108b and second source or drain regions 106b along the first direction. Each of first inner spacers 112 and second inner spacers 114 may separate adjacent nanoribbons 104a/104b from one another along a third direction (e.g., a vertical direction). According to some embodiments, each of first inner spacers 112 and second inner spacers 114 include a low-k dielectric material, such as silicon dioxide, or any other dielectric material having a dielectric constant less than silicon dioxide. As such, inner spacers 112/114 may have a different material compared to spacer structures 110. In one example, spacer structures 110 include silicon nitride and inner spacers 112/114 include silicon dioxide. In general, inner spacers 112/114 may include a material having a lower dielectric constant compared to the material of spacer structures 110. According to some embodiments, first inner spacers 112 laterally protrude beyond the ends of first nanoribbons 104a along the first direction. First inner spacers 112 may protrude beyond the ends of first nanoribbons 104a by, for example, between about 1 nm and about 4 nm, although other examples may be configured differently. The protrusions themselves may have a triangular or faceted cross-section as illustrated in Figure 1A, although other shapes (e.g., rounded or rectangular) may result depending on factors such as crystalline orientation and composition (e.g., monocrystalline v. polycrystalline) of the source or drain material. The expanded view illustrates another example of first inner spacer 112 having a more rounded profile that could result from an isotropic etching process.

According to some embodiments, a dielectric fill 116 may be used within the source/drain trenches over both first source or drain regions 106a and second source or drain regions 106b. Dielectric fill 116 may be any suitable dielectric material, such as silicon dioxide or silicon oxynitride. In some examples, dielectric fill 116 extends along the source/drain trench in the second direction (into and out of the page) between adjacent source or drain regions along the source/drain trench. In some examples, one or more topside conductive contacts may be formed through dielectric fill 116 to contact top surfaces of any of source or drain regions 106a/106b.

According to some embodiments, one or more isolation structures 118 may be formed adjacent that cut across one or more fins to isolate devices on either side of the isolation structure. Isolation structures 118 may include one or more dielectric materials that extend in the second direction within a gate trench to cut through any number of fins present within the gate trench. In the illustrated example, isolation structures 118 extend along the second direction on either side of first semiconductor device 101 and second semiconductor device 103 to isolate such devices from any other devices formed along the first direction. Isolation structures 118 may include any suitable dielectric material, such as silicon nitride or any other high-k dielectric material. According to some embodiments, isolation structures 118 extend in the third direction along at least an entire height of the adjacent source or drain regions 106a/106b. A top surface of isolation structures 118 may be substantially coplanar with a top surface of spacer structures 110. In the example shown, isolation structures 118 extend through an entire thickness of doped wells 102b/120c, such that isolation structures 118 extend into bulk substrate 102a. Isolation structures 118 may not be needed in situations where adjacent devices along the first direction are intended to share a given source or drain region (or where dummy transistors are employed).

### Fabrication Methodology

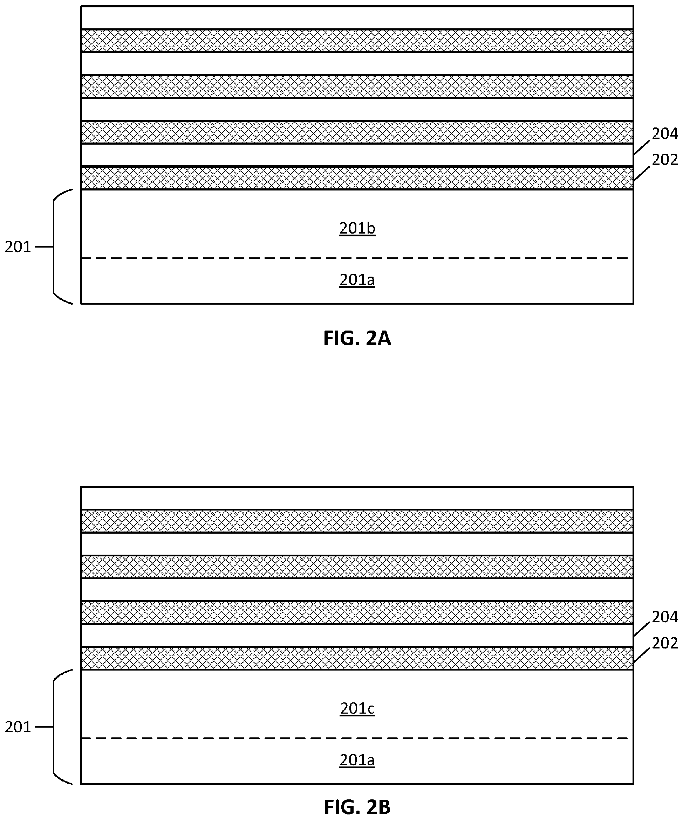

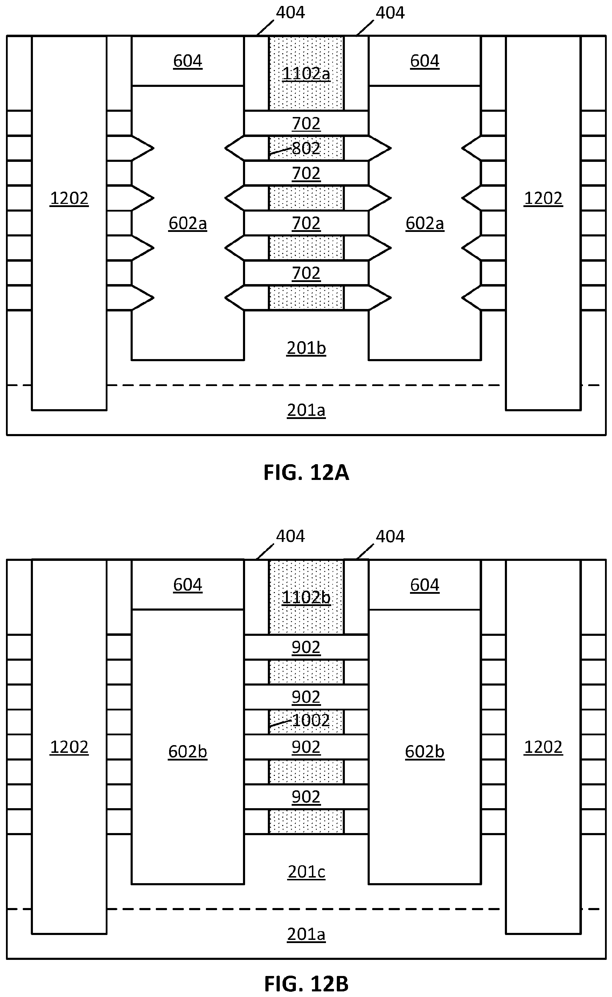

Figures 2A - 12A and 2B - 12B include cross-sectional views that collectively illustrate an example process for forming an integrated circuit that includes semiconductor devices with low-k inner spacers, in accordance with an embodiment of the present disclosure. Figures 2A - 12A represent a similar cross-sectional view as that of Figure 1A, while Figures 2B - 12B represent a similar cross-sectional view as that of Figure 1B. Each set of figures sharing the same letter shows an example structure that results from the process flow up to that point in time, so the depicted structure evolves as the process flow continues, culminating in the structure shown in Figures 12A and 12B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure.

Figures 2A and 2B each illustrates a cross-sectional view taken through a substrate 201 having a series of material layers formed over substrate 201, according to an embodiment of the present disclosure. Alternating material layers may be deposited over substrate 201 including sacrificial layers 202 alternating with semiconductor layers 204. The alternating layers are used to form GAA transistor structures. Any number of alternating sacrificial layers 202 and semiconductor layers 204 may be deposited over substrate 201. Substrate 201 may include a bulk portion 201a, first doped well 201b, and second doped well 201c, which are similar to bulk portion 102a, first doped well 102b, and second doped well 102c discussed above with reference to Figures 1A and 1B.

According to some embodiments, semiconductor layers 204 have a different material composition than sacrificial layers 202. In some embodiments, semiconductor layers 204 include a semiconductor material suitable for use as a nanoribbon such as silicon (Si), SiGe, germanium, or III-V materials like indium phosphide (InP) or gallium arsenide (GaAs). Sacrificial layers 202 include a material that can be selectively removed relative to semiconductor layers 204. In some examples, for instance, semiconductor layers 204 are silicon and sacrificial layers 202 are SiGe, or vice-versa. In some other examples where SiGe is used in each of semiconductor layers 204 and in sacrificial layers 202, the germanium concentration is different between semiconductor layers 204 and sacrificial layers 202, so as to allow for etch selectivity. For example, semiconductor layers 204 may include a higher germanium content compared to sacrificial layers 202.

While dimensions can vary from one example embodiment to the next, the thickness of each semiconductor layer 204 may be between about 5 nm and about 20 nm, such as between about 6 nm and about 10 nm. In some embodiments, the thickness of each semiconductor layer 204 is substantially the same (e.g., within 1 nm). The thickness of each of sacrificial layers 202 may be about the same as the thickness of each semiconductor layer 204 (e.g., about 6 - 10 nm). Each of semiconductor layers 204 and sacrificial layers 202 may be deposited using any material deposition technique, such as chemical vapor deposition (CVD), plasma-enhanced chemical vapor deposition (PECVD), physical vapor deposition (PVD), or atomic layer deposition (ALD), or epitaxial growth.

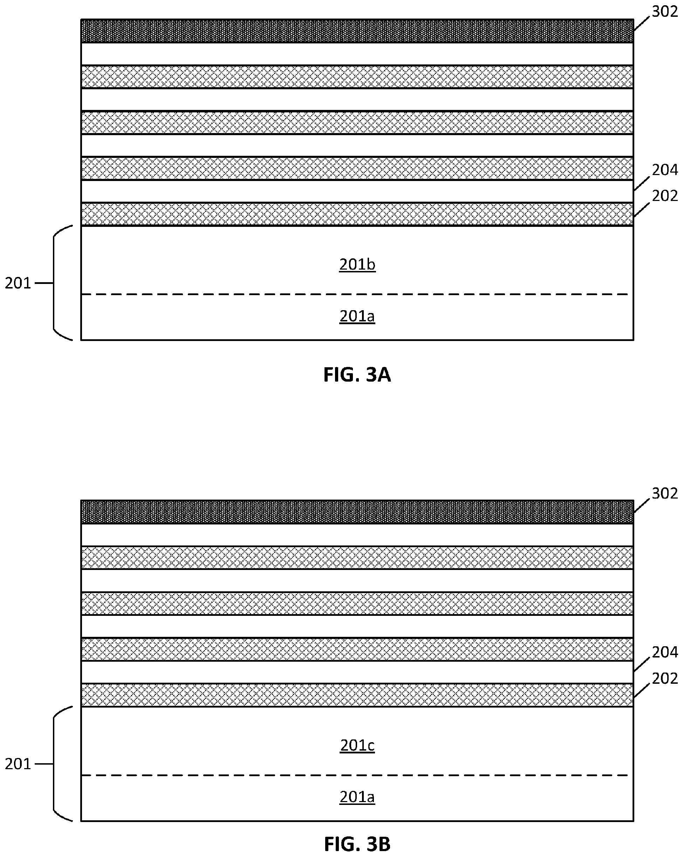

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. Cap layer 302 extends along the top of each fin in a first direction.

According to some embodiments, an anisotropic etching process through the layer stack continues into at least a portion of substrate 201 (such as through at least the thickness of doped wells 201b/201c. Portions of substrate 201 beneath the fins are not etched and yield subfin regions. The etched portions of substrate 201 that are not under the fins may be filled with a dielectric fill that acts as shallow trench isolation (STI) between adjacent fins. The dielectric fill may be any suitable dielectric material such as silicon dioxide.

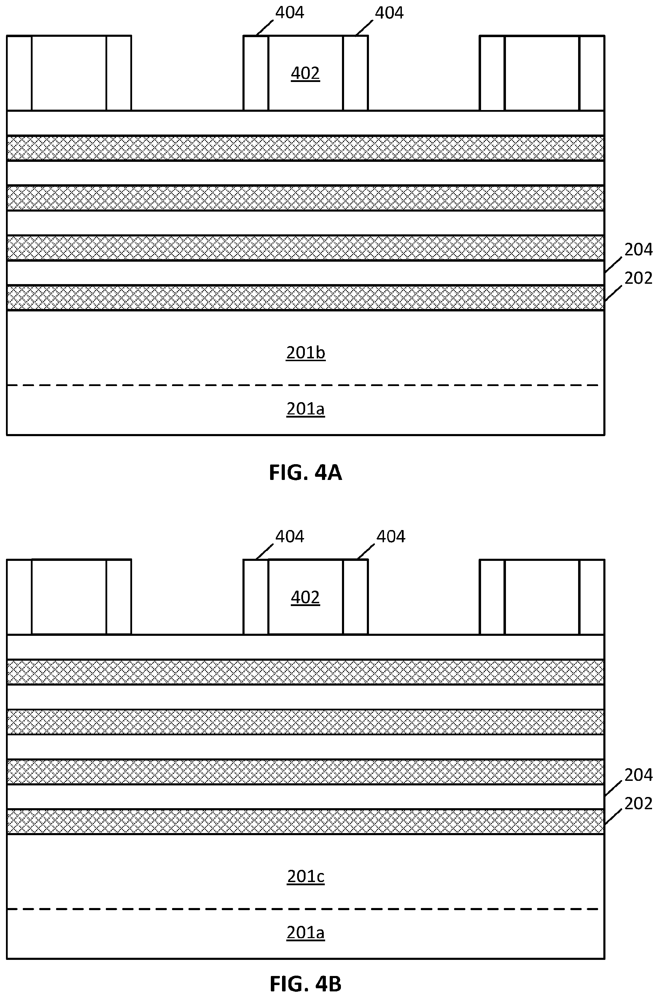

Figures 4A and 4B depict cross-section views of the structures shown in Figures 3A and 3B following the formation of sacrificial gates 402 and spacer structures 404 (also referred to as upper gate spacer), according to some embodiments. A gate masking layer may first be patterned in strips that extend orthogonally across each of the fins (e.g., in a second direction) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gate 402 may be any suitable material that can be selectively removed without damaging the semiconductor material of the fins. In some examples, sacrificial gate 402 includes polysilicon.

According to some embodiments, spacer structures 404 are formed along the sidewalls of sacrificial gates 402. Spacer structures 404 may be conformally deposited (e.g., CVD or ALD)_and then etched back or otherwise removed (e.g., via anisotropic or directional etch) from horizontal surfaces, such that spacer structures 404 remain mostly only on sidewalls of any exposed structures. The width of spacer structures 404 (along the first direction) may vary from one example to the next, but in some cases is in the range of 3 nm to 20 nm. According to some embodiments, spacer structures 404 may be any suitable dielectric material, such as silicon nitride, silicon carbon nitride, or silicon oxycarbonitride.

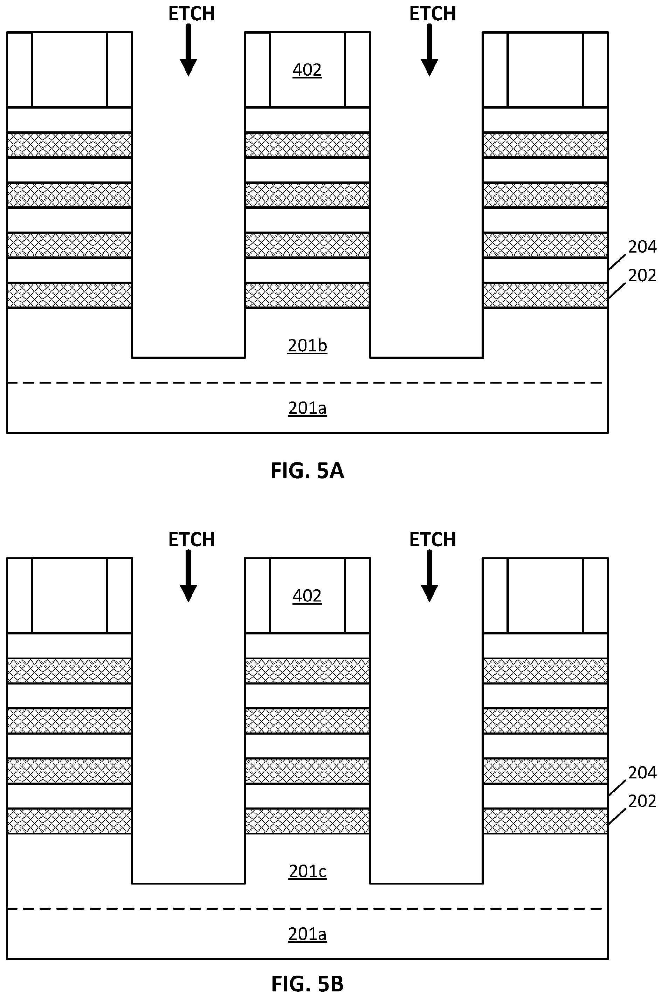

Figures 5A and 5B depict cross-section views of the structures shown in Figures 4A and 4B following the removal of exposed portions of the fins not protected by sacrificial gates 402 and spacer structures 404, according to some embodiments. The exposed fin portions may be removed using any anisotropic etching process, such as reactive ion etching (RIE) or other directional etch process. The removal of the exposed fin portions creates source or drain trenches that alternate with gate trenches (currently filled with sacrificial gates 402) along the first direction, according to some embodiments. In some embodiments, at least a portion of first doped well 201b and second doped well 201c are also removed at the bottom of the recesses.

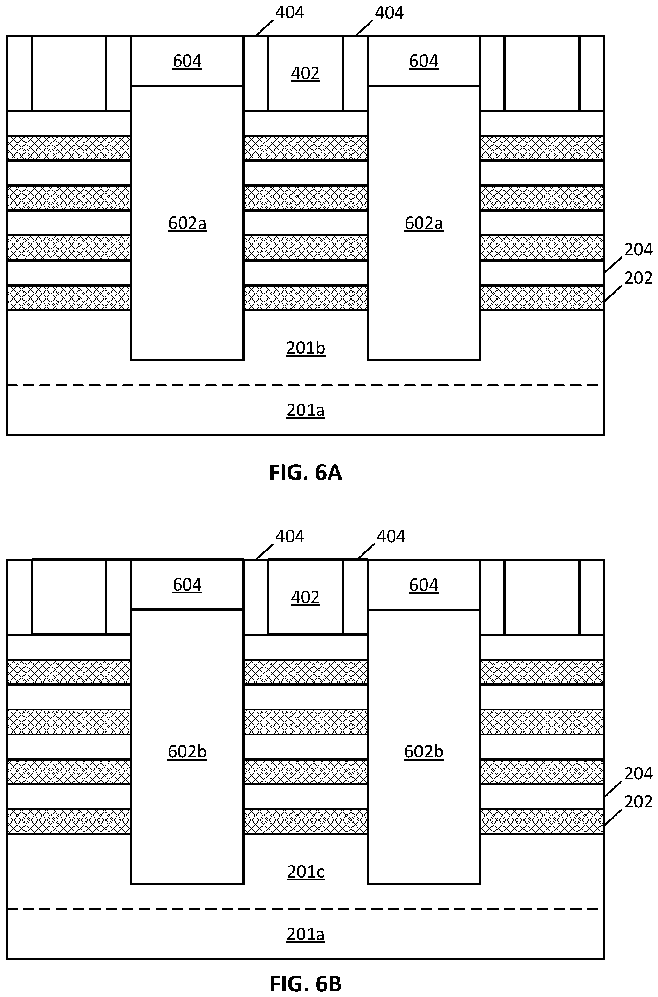

Figures 6A and 6B depict cross-section views of the structures shown in Figures 5A and 5B following the formation of first source or drain regions 602a and second source or drain regions 602b within the source/drain trenches of the different devices, according to some embodiments. Source or drain regions 602a/602b may be formed in the areas that had been previously occupied by the exposed fins between spacer structures 404. According to some embodiments, source or drain regions 602a/602b are epitaxially grown from the exposed semiconductor material at the ends of both semiconductor layers 204 and sacrificial layers 202. Lower portions of source or drain regions 602a/602b may also be grown from the exposed surfaces of first doped well 201b and second doped well 201c.

According to some embodiments, first source or drain regions 602a are formed before second source or drain regions 602b, or vice versa. First source or drain regions 602a may be p-type source or drain regions having silicon germanium and second source or drain regions 602b may be n-type source or drain regions having silicon. Since source or drain regions 602a/602b are grown along a continuous semiconductor surface (e.g., the alternating layers of semiconductor layers 204 and sacrificial layers 202), they provide a relatively high tensile or compressive stress (e.g., about 1 to 2 GPa) to semiconductor layers 204.

According to some embodiments, a dielectric fill 604 is provided over source or drain regions 602a/602b. In some examples, dielectric fill 604 occupies a remaining volume within the source/drain trenches around and over portions of source or drain regions 602a/602b. Dielectric fill 604 may be any suitable dielectric material, such as silicon dioxide. In some examples, dielectric fill 604 extends up to and planar with a top surface of spacer structures 404 (e.g., following a polishing procedure).

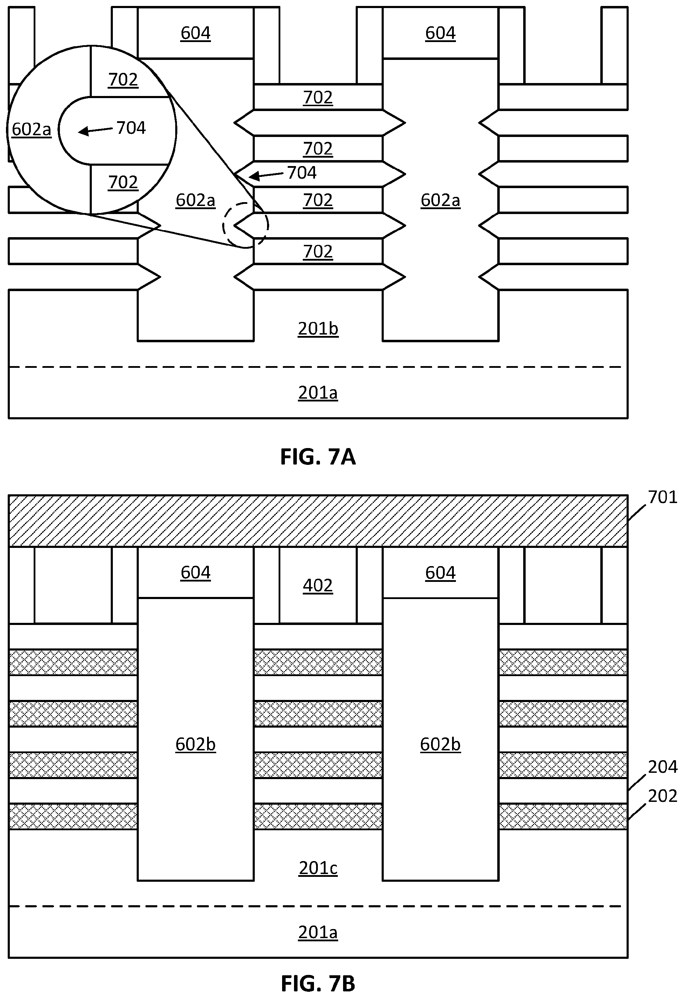

Figures 7A and 7B depict cross-section views of the structures shown in Figures 6A and 6B following the removal of sacrificial gates 402 and sacrificial layers 202 for one or more fins (Figure 7A) while one or more other fins are protected (Figure 7B), according to some embodiments. A mask structure 701 may be formed over one or more fins to protect them during the processing of exposed fins not protected by mask structure 701. According to some embodiments, mask structure 701 includes any suitable dielectric hard mask material, such as carbon hard mask (CHM).

According to some embodiments, sacrificial layers 202 are selectively removed to leave behind first nanoribbons 702 that extend between corresponding first source or drain regions 602a. Each vertical set of first nanoribbons 702 represents the semiconductor region (also called channel region or channel body) of a different semiconductor device. It should be understood that first nanoribbons 702 may also be nanowires or nanosheets. Sacrificial gates 402 and sacrificial layers 202 may be removed using the same isotropic etching process or different isotropic etching processes.

The etching process used to remove sacrificial layers 202 from within the gate trench may also etch exposed surfaces of first source or drain regions 602a. This may be due to the material similarity between the p-type first source or drain regions 602a and sacrificial layers 202. Thus, according to some embodiments, lateral cavities 704 may be formed within first source or drain regions 602a between first nanoribbons 702. Lateral cavities 704 may protrude outward beyond the ends of first nanoribbons 702 along the first direction. In some examples, lateral cavities 704 protrude beyond the ends of first nanoribbons 702 by between about 1 nm and about 4 nm. As further shown, lateral cavities 704 protrude into source and drain regions 602a. Faceting may occur, as shown, but in other examples lateral cavities 704 may have a rounded or rectangular shape. The expanded view in Figure 7A illustrates another example of a lateral cavity 704 having a more rounded profile that could result from an isotropic etching process during the removal of sacrificial layers 202 and portions of first source or drain regions 602a.

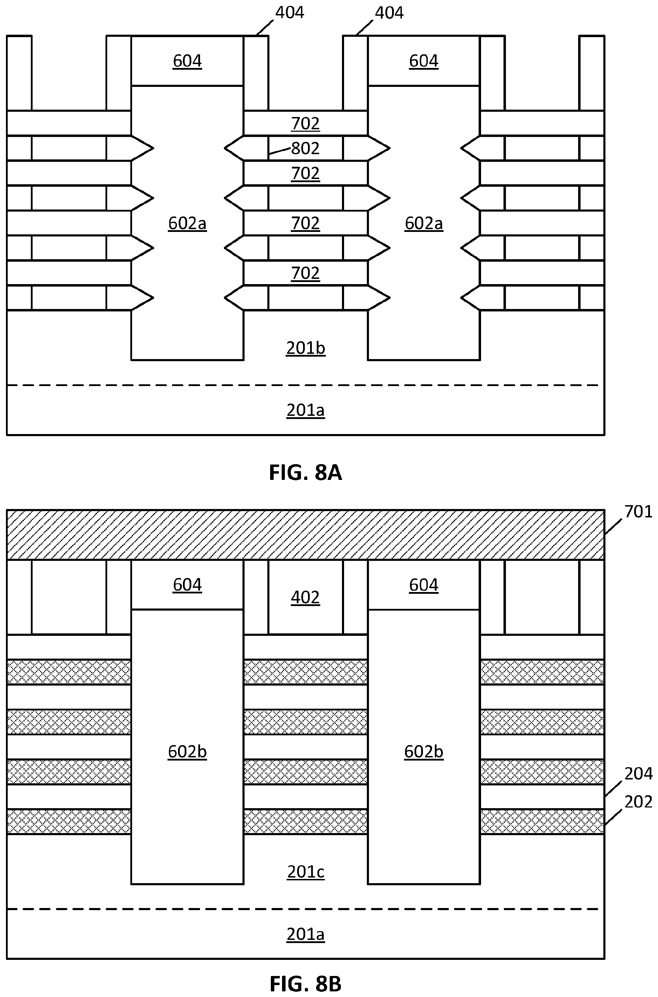

Figures 8A and 8B depict cross-section views of the structures shown in Figures 7A and 7B following the formation of first inner spacers 802, according to some embodiments. A portion of first inner spacers 802 may also be formed within lateral cavities 704. According to some embodiments, first inner spacers 802 include a low-k dielectric material, such as silicon dioxide. First inner spacers 802 may be formed using any number of different techniques. In one example, the dielectric material of first inner spacers 802 is selectively grown from the exposed surfaces of source or drain regions 602a. The growth of the dielectric material may be controlled such that first inner spacers 802 extend into the gate trench about the same distance as spacer structures 404. In another example, the dielectric material of first inner spacers 802 is formed using a series of deposition and etch processes that over time accumulates the dielectric material within the lateral cavities 704 and around the ends of first nanoribbons 702 beneath spacer structures 404. Any other techniques may be used as well to form first inner spacers 802. As shown in this example, inner spacers 802 each has an end that extends laterally into source and drain regions 602a, such that the ends of inner spacers 802 are laterally inward of, and not collinear with, the innermost surface of corresponding upper gate spacer 404.

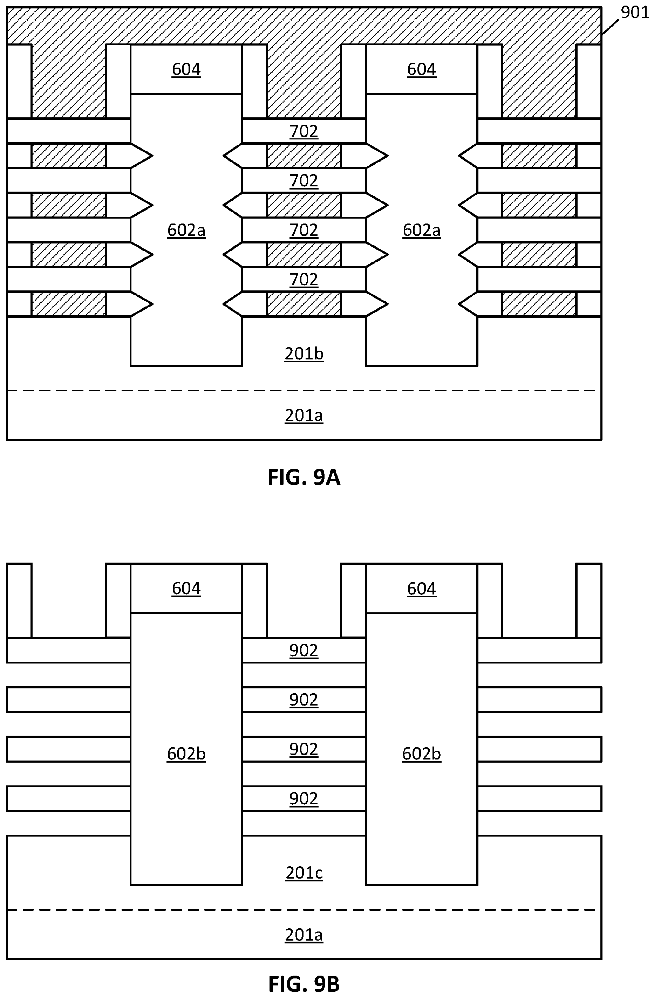

Figures 9A and 9B depict cross-section views of the structures shown in Figures 8A and 8B following the removal of sacrificial gates 402 and sacrificial layers 202 for the one or more other fins (Figure 9B) while the devices with released nanoribbons are protected (Figure 9A), according to some embodiments. A mask structure 901 may be formed over one or more devices to protect them during the processing of exposed fins not protected by mask structure 901. According to some embodiments, mask structure 901 includes any suitable dielectric hard mask material, such as CHM.

According to some embodiments, sacrificial layers 202 are selectively removed to leave behind second nanoribbons 902 that extend between corresponding second source or drain regions 602b. Each vertical set of second nanoribbons 902 represents the semiconductor region (also called channel region) of a different semiconductor device. It should be understood that second nanoribbons 902 may also be nanowires or nanosheets. Sacrificial gates 402 and sacrificial layers 202 may be removed using the same isotropic etching process or different isotropic etching processes.

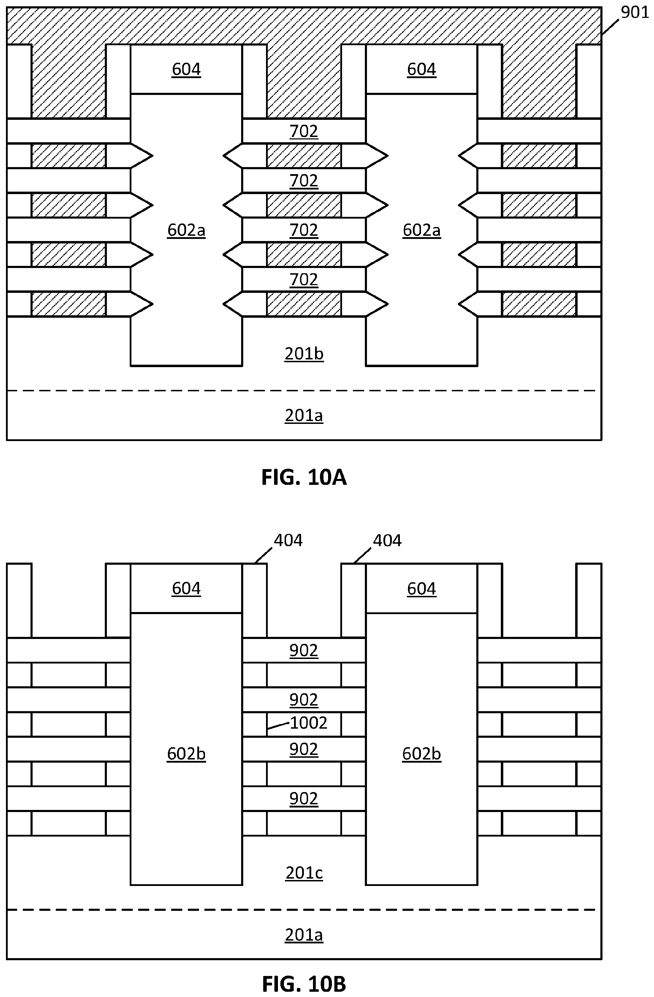

Figures 10A and 10B depict cross-section views of the structures shown in Figures 9A and 9B following the formation of second inner spacers 1002, according to some embodiments. Second inner spacers 1002 include a low-k dielectric material, such as silicon dioxide, according to some embodiments. Second inner spacers 1002 may be formed using any number of different techniques, such as any of the techniques discussed above for the formation of first inner spacers 802. In some embodiments, first inner spacers 802 and second inner spacers 1002 are formed using the same process at the same time (e.g., no masking layers 701/901 are used), following the removal of sacrificial gates 402 and sacrificial layers 202 from all fins. As further shown in this example, inner spacers 1002 each has an end that is collinear with the innermost surface of corresponding upper gate spacer 404. Note that, even if the recesses in which source and drain regions 602 are formed naturally tapered inward, such collinearity would still be maintained along that tapered sidewall of the recess.

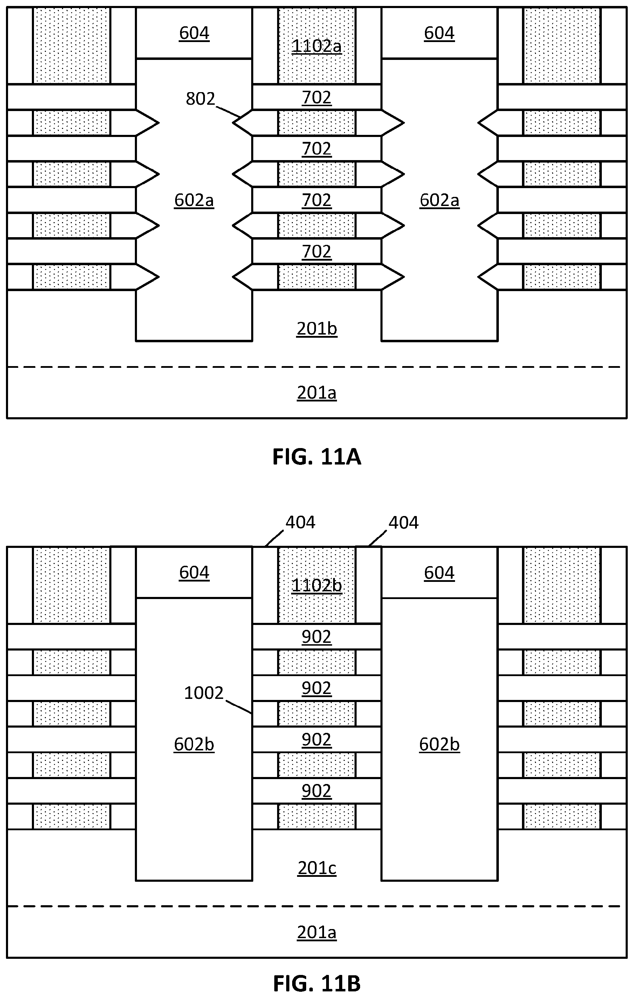

Figures 11A and 11B depict cross-section views of the structure shown in Figures 10A and 10B, respectively, following the formation of a first gate structure 1102a around first nanoribbons 702 and a second gate structure 1102b around second nanoribbons 902, according to some embodiments. Each gate structure includes a gate dielectric and a gate electrode on the gate dielectric. The gate dielectric may be formed around nanoribbons 702/902 and along any exposed surfaces within the gate trenches, such as along sidewalls of spacer structures 404, first inner spacers 802, and second inner spacers 1002. The gate dielectric may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on nanoribbons 702/902, and a second layer on the first layer. The first layer can be, for instance, an oxide of the semiconductor material of nanoribbons 702/902 (e.g., silicon dioxide) and the second layer can be a high-k dielectric material (e.g., hafnium oxide or aluminum oxide). Any excess gate dielectric may be removed from the top surface of the structure, for instance, via a polishing process (e.g., chemical mechanical polishing, CMP).

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

Figures 12A and 12B depict cross-section views of the structure shown in Figures 11A and 11B, respectively, following the formation of isolation structures 1202 through one or more gate trenches, according to some embodiments. Isolation structures 1202 may include any number of dielectric materials and can extend across any number of fins along the second direction (into and out of the page). In the illustrated example, isolation structures 1202 isolate first semiconductor device 101 from any other adjacent devices along the first direction, and also isolate second semiconductor device 103 from any other adjacent devices along the first direction.

According to some embodiments, an RIE process is performed to etch openings through the gate trenches. The etch removes any exposed portion of the gate structure and nanoribbons within the gate trench. According to some embodiments, the openings extend through at least an entire height of the gate structures 1102a/1102b and into a portion of the substrate. In some examples, the openings extend through an entire height of doped wells 201b/201c into at least a portion of bulk substrate 201a. The openings may be filled with any number of dielectric materials to form isolation structures 1202. The dielectric material may be deposited using any suitable conformal deposition technique, such as ALD, CVD, or PECVD. The dielectric material may be any suitable dielectric, such as silicon nitride. According to some embodiments, the dielectric material is deposited and then polished back such that a top surface of isolation structures 1202 is substantially coplanar with a top surface of spacer structures 404.

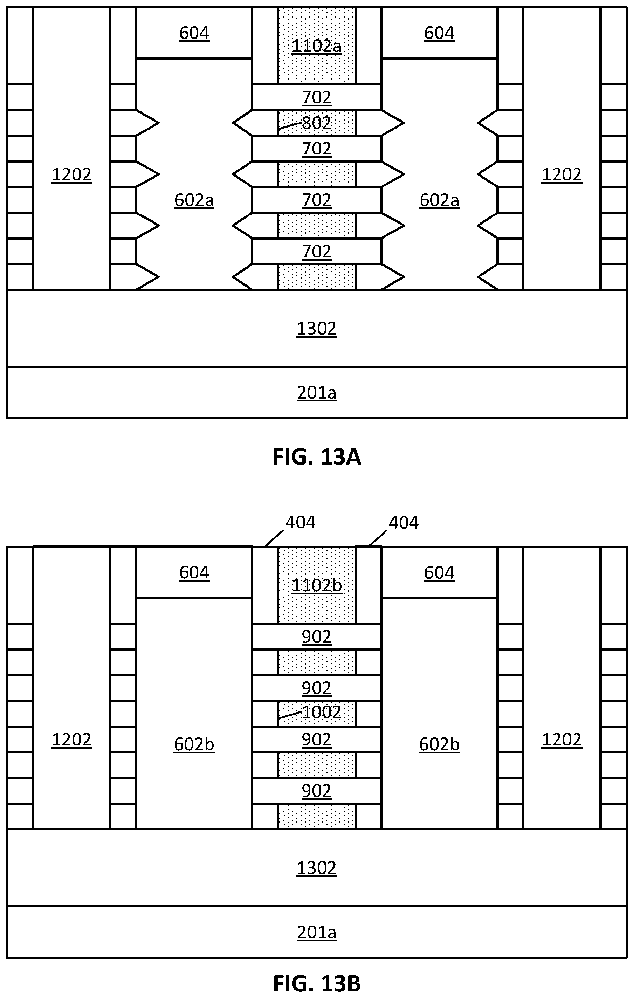

As noted above, some devices may be formed over a base dielectric layer, such as the case of silicon-on-insulator (SOI) substrates, rather than using doped wells 201b/201c. Figures 13A and 13B illustrate semiconductor devices 101 and 103 formed over base dielectric layer 1302 having bulk substrate 201a beneath base dielectric layer 1302, according to some embodiments. Base dielectric layer 1302 may be any suitable dielectric material, such as silicon dioxide. According to some embodiments, first source or drain regions 602a and second source or drain regions 602b do not extend into base dielectric layer 1302, as the base dielectric layer 1302 acts as an effective etch stop when forming the source/drain trenches. Bulk substrate 201a may remain to provide structural integrity, or may be removed and replaced with a backside interconnect region for routing signal or power to the devices.

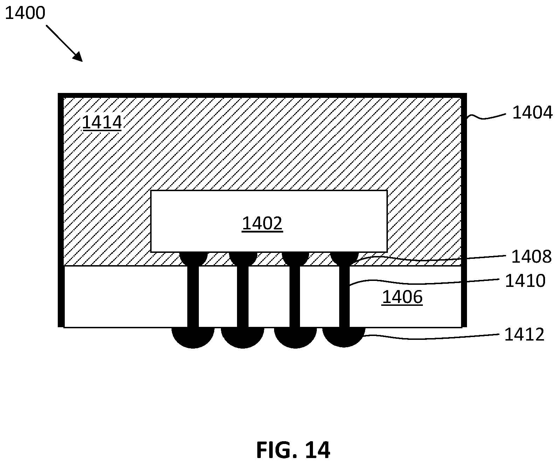

Figure 14 illustrates an example embodiment of a chip package 1400, in accordance with an embodiment of the present disclosure. As can be seen, chip package 1400 includes one or more dies 1402. One or more dies 1402 may include at least one integrated circuit having semiconductor devices, such as any of the semiconductor devices disclosed herein. One or more dies 1402 may include any other circuitry used to interface with other devices formed on the dies, or other devices connected to chip package 1400, in some example configurations.

As can be further seen, chip package 1400 includes a housing 1404 that is bonded to a package substrate 1406. The housing 1404 may be any standard or proprietary housing, and may provide, for example, electromagnetic shielding and environmental protection for the components of chip package 1400. The one or more dies 1402 may be conductively coupled to a package substrate 1406 using connections 1408, which may be implemented with any number of standard or proprietary connection mechanisms, such as solder bumps, ball grid array (BGA), pins, or wire bonds, to name a few examples. Package substrate 1406 may be any standard or proprietary package substrate, but in some cases includes a dielectric material having conductive pathways (e.g., including conductive vias and lines) extending through the dielectric material between the faces of package substrate 1406, or between different locations on each face. In some embodiments, package substrate 1406 may have a thickness less than 1 millimeter (e.g., between 0.1 millimeters and 0.5 millimeters), although any number of package geometries can be used. Additional conductive contacts 1412 may be disposed at an opposite face of package substrate 1406 for conductively contacting, for instance, a printed circuit board (PCB). One or more vias 1410 extend through a thickness of package substrate 1406 to provide conductive pathways between one or more of connections 1408 to one or more of contacts 1412. Vias 1410 are illustrated as single straight columns through package substrate 1406 for ease of illustration, although other configurations can be used (e.g., damascene, dual damascene, through-silicon via, or an interconnect structure that meanders through the thickness of substrate 1406 to contact one or more intermediate locations therein). In still other embodiments, vias 1410 are fabricated by multiple smaller stacked vias, or are staggered at different locations across package substrate 1406. In the illustrated embodiment, contacts 1412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1412, to inhibit shorting.

In some embodiments, a mold material 1414 may be disposed around the one or more dies 1402 included within housing 1404 (e.g., between dies 1402 and package substrate 1406 as an underfill material, as well as between dies 1402 and housing 1404 as an overfill material). Although the dimensions and qualities of the mold material 1414 can vary from one embodiment to the next, in some embodiments, a thickness of mold material 1414 is less than 1 millimeter. Example materials that may be used for mold material 1414 include epoxy mold materials, as suitable. In some cases, the mold material 1414 is thermally conductive, in addition to being electrically insulating.

### Methodology

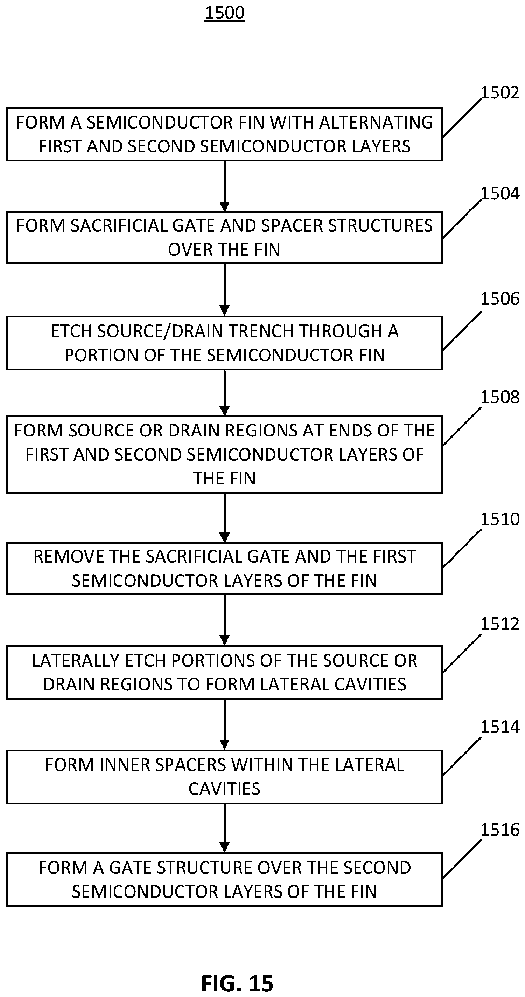

Figure 15 is a flow chart of a method 1500 for forming at least a portion of an integrated circuit, according to an embodiment. Various operations of method 1500 may be illustrated in Figures 2A - 12A and 2B - 12B. However, the correlation of the various operations of method 1500 to the specific components illustrated in the aforementioned figures is not intended to imply any structural and/or use limitations. Rather, the aforementioned figures provide one example embodiment of method 1500. Other operations may be performed before, during, or after any of the operations of method 1500. For example, method 1500 does not explicitly describe various standard processes that are usually performed to form transistor structures. Some of the operations of method 1500 may be performed in a different order than the illustrated order.

Method 1500 begins with operation 1502 where a semiconductor fin is formed, according to some embodiments. The fin may be part of a plurality of similar fins formed across a substrate. The fin can be formed of material deposited onto an underlying substrate. In some embodiments, the fin includes alternating layers of material (e.g., alternating first and second layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating first and second layers can be blanket deposited and then etched into fins, or deposited into fin-shaped trenches, according to some examples. The fin may also include a cap structure that is used to define the location of the fin during, for example, an RIE process. The cap structure may be a dielectric material, such as silicon nitride.

Method 1500 continues with operation 1504 where a sacrificial gate is formed over the fin. The sacrificial gate may be part of a plurality of sacrificial gates patterned using gate masking layers in strips that run orthogonally over various fins and parallel to one another (e.g., forming a cross-hatch pattern). The gate masking layers may be any suitable hard mask material, such as CHM or silicon nitride. The sacrificial gate itself may be formed from any suitable material that can be selectively removed at a later time without damaging the semiconductor material of the fin. In one example, the sacrificial gate includes polysilicon.

According to some embodiments, spacer structures are also formed on sidewalls of the sacrificial gate. The spacer structures may be deposited and then etched back such that the spacer structures remain mostly only on sidewalls of any exposed structures. In some cases, spacer structures may also be formed along sidewalls of the exposed fin running orthogonally between the strips of sacrificial gates. According to some embodiments, the spacer structures may be any suitable dielectric material, such as silicon nitride or silicon oxynitride.

Method 1500 continues with operation 1506 where exposed portions of the fin are removed to form source/drain trenches. Any exposed portions of the fin not covered by the sacrificial gate or spacer structures may be removed using any anisotropic etching process, such as reactive ion etching (RIE). In some examples, portions of the subfin may also be removed during this process.

Method 1500 continues with operation 1508 where source or drain regions are formed at opposite ends of the fin on the first and second semiconductor layers within the source/drain trenches. The source or drain regions may be formed in the areas that had been previously occupied by the exposed fin between the spacer structures. According to some embodiments, the source or drain regions are epitaxially grown from the ends of the first and second semiconductor layers. In some example embodiments, the source or drain regions are NMOS source or drain regions (e.g., epitaxial silicon with n-type dopants) or PMOS source or drain regions (e.g., epitaxial SiGe with p-type dopants). A dielectric fill may be formed between and over the source or drain regions along a given source/drain trench. The dielectric fill may be any suitable dielectric material, such as silicon dioxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth or may include a gate cut structure separating them.

Method 1500 continues with operation 1510 where the sacrificial gate is removed. According to some embodiments, the sacrificial gate may be removed along with any sacrificial layers (e.g., the first semiconductor layers) of the exposed fin within the gate trench. The sacrificial gate and/or sacrificial layers may be removed using any suitable isotropic etching process. The removal of the fin's sacrificial layers leaves behind semiconductor nanoribbons (or nanowires or nanosheets) extending along the first direction between the source or drain regions.

Method 1500 continues with operation 1512 where portions of the source or drain regions are laterally etched to form lateral cavities. In examples where the source or drain regions are p-type regions (e.g., having silicon germanium), the etch used in operation 1510 to remove the sacrificial layers may also remove exposed portions of the source or drain regions between the nanoribbons. Such recessing of portions of the source or drain regions may not occur for n-type regions (e.g., having silicon) due to the etch selectivity between silicon and silicon germanium. In some examples, the lateral cavities extend into the source or drain regions by between about 1 nm and about 4 nm.

Method 1500 continues with operation 1514 where inner spacers are formed around the ends of the nanoribbons and adjacent to the exposed surfaces of the source or drain regions. In examples where lateral cavities in the source or drain regions are present, the inner spacers are also formed within the lateral cavities. According to some embodiments, the inner spacers include a low-k dielectric material, such as silicon dioxide or another suitable dielectric material with a dielectric constant less than 3.9.

The inner spacers may be formed using any number of various techniques. In one example, the dielectric material of the inner spacers is epitaxially grown from the exposed surfaces of the source or drain regions. The growth of the dielectric material may be controlled such that the inner spacers extend into the gate trench about the same distance as the spacer structures. In another example, the dielectric material of the inner spacers is formed using a series of deposition and etch processes that over time accumulates the dielectric material within the lateral cavities and around the ends of the nanoribbons beneath the spacer structures.

Method 1500 continues with operation 1516 where a gate structure is formed over the semiconductor nanoribbons within the gate trench. The gate structure may be formed in the space previously occupied by the sacrificial gate and the sacrificial layers of the fin. The gate structure may include both a gate dielectric and a gate electrode. The gate dielectric is first formed over the exposed semiconductor nanoribbons followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

### Example System

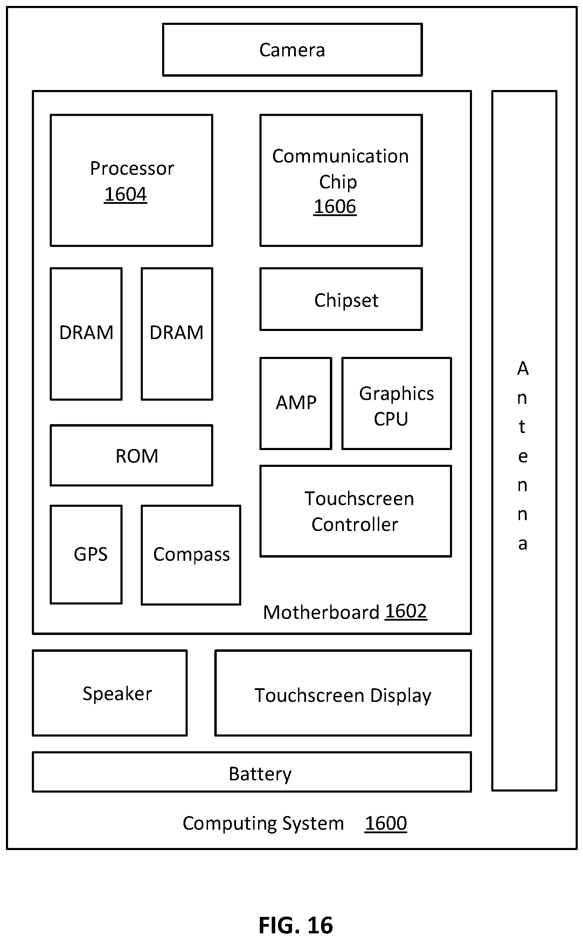

FIG. 16 is an example computing system implemented with one or more of the integrated circuit structures as disclosed herein, in accordance with some embodiments of the present disclosure. As can be seen, the computing system 1600 houses a motherboard 1602. The motherboard 1602 may include a number of components, including, but not limited to, a processor 1604 and at least one communication chip 1606, each of which can be physically and electrically coupled to the motherboard 1602, or otherwise integrated therein. As will be appreciated, the motherboard 1602 may be, for example, any printed circuit board (PCB), whether a main board, a daughterboard mounted on a main board, or the only board of system 1600, etc.

Depending on its applications, computing system 1600 may include one or more other components that may or may not be physically and electrically coupled to the motherboard 1602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1600 may include one or more integrated circuit structures or devices configured in accordance with an example embodiment (e.g., a module including an integrated circuit device on a substrate, the substrate having GAA semiconductor devices with low-k inner spacers, as variously provided herein). In some embodiments, multiple functions can be integrated into one or more chips (e.g., for instance, note that the communication chip 1606 can be part of or otherwise integrated into the processor 1604).

The communication chip 1606 enables wireless communications for the transfer of data to and from the computing system 1600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1600 may include a plurality of communication chips 1606. For instance, a first communication chip 1606 may be dedicated to shorter range wireless communications such as Wi-Fi and Bluetooth and a second communication chip 1606 may be dedicated to longer range wireless communications such as GPS, EDGE, GPRS, CDMA, WiMAX, LTE, Ev-DO, and others.

The processor 1604 of the computing system 1600 includes an integrated circuit die packaged within the processor 1604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1606 also may include an integrated circuit die packaged within the communication chip 1606. In accordance with some such example embodiments, the integrated circuit die of the communication chip includes one or more semiconductor devices as variously described herein. As will be appreciated in light of this disclosure, note that multi-standard wireless capability may be integrated directly into the processor 1604 (e.g., where functionality of any chips 1606 is integrated into processor 1604, rather than having separate communication chips). Further note that processor 1604 may be a chip set having such wireless capability. In short, any number of processor 1604 and/or communication chips 1606 can be used. Likewise, any one chip or chip set can have multiple functions integrated therein.

In various implementations, the computing system 1600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor device having one or more semiconductor bodies (e.g., nanoribbons) extending in a first direction from a source or drain region and a gate structure extending in a second direction over the one or more semiconductor bodies, and dielectric spacers adjacent to ends of the semiconductor bodies. The dielectric spacers are between the gate structure and the source or drain region along the first direction. The dielectric spacers laterally protrude beyond the ends of the semiconductor bodies along the first direction and into the source or drain region.

Example 2 includes the integrated circuit of Example 1, wherein the second direction is substantially orthogonal to the first direction, and the dielectric spacers are aligned over one another along a third direction substantially orthogonal to the first and second directions.

Example 3 includes the integrated circuit of Example 1 or 2, further comprising spacer structures on sidewalls of at least a top portion of the gate structure.

Example 4 includes the integrated circuit of Example 3, wherein the spacer structures comprise a dielectric material with a higher dielectric constant compared to the dielectric material of the dielectric spacers.

Example 5 includes the integrated circuit of Example 4, wherein the spacer structures comprise silicon and nitrogen and the dielectric spacers comprise silicon and oxygen.

Example 6 includes the integrated circuit of any one of Examples 1-5, wherein the one or more semiconductor bodies comprise one or more nanoribbons or nanosheets.

Example 7 includes the integrated circuit of any one of Examples 1-6, wherein the one or more semiconductor bodies comprise germanium, silicon, or a combination thereof.

Example 8 includes the integrated circuit of any one of Examples 1-7, wherein the dielectric spacers protrude beyond the ends of the semiconductor bodies by between about 1 nm and about 4 nm.

Example 9 includes the integrated circuit of any one of Examples 1-8, wherein the dielectric spacers extend into the source or drain region by about 1 nm and about 4 nm.

Example 10 includes the integrated circuit of any one of Examples 1-9, wherein the dielectric spacers each has a faceted end that extends into the source or drain region.

Example 11 includes the integrated circuit of any one of Examples 1-9, wherein the dielectric spacers each has a rounded end that extends into the source or drain region.

Example 12 includes the integrated circuit of any one of Examples 1-11, comprising an upper gate spacer above the dielectric spacers and having an innermost surface contacting a sidewall of the gate structure, wherein the dielectric spacers each has an end that extends laterally into the source or drain region, such that the ends of the dielectric spacers are laterally inward of, and not collinear with, the innermost surface of the upper gate spacer.

Example 13 includes the integrated circuit of any one of Examples 1-12, wherein the source or drain region is a p-type source or drain region.

Example 14 is a die that includes the integrated circuit of any one of Examples 1-13.

Example 15 is an electronic device having a chip package with one or more dies. At least one of the one or more dies includes one or more semiconductor bodies (e.g., nanoribbons) extending in a first direction from a first source or drain region to a second source or drain region, a gate structure extending in a second direction over the one or more semiconductor bodies, first dielectric spacers adjacent to first ends of the semiconductor bodies, and second dielectric spacers adjacent to second ends of the semiconductor bodies. The first dielectric spacers are between the gate structure and the first source or drain region along the first direction and the second dielectric spacers are between the gate structure and the second source or drain region along the first direction. The first dielectric spacers laterally protrude beyond the first ends of the semiconductor bodies along the first direction and the second dielectric spacers laterally protrude beyond the second ends of the semiconductor nanoribbons along the second direction.

Example 16 includes the electronic device of Example 15, wherein the second direction is substantially orthogonal to the first direction, and the first dielectric spacers are aligned over one another along a third direction substantially orthogonal to the first and second directions, and the second dielectric spacers are aligned over one another along the third direction.

Example 17 includes the electronic device of Example 15 or 16, further comprising spacer structures on sidewalls of at least a top portion of the gate structure.

Example 18 includes the electronic device of Example 17, wherein the spacer structures comprise a dielectric material with a higher dielectric constant compared to the dielectric material of the first and second dielectric spacers.

Example 19 includes the electronic device of Example 18, wherein the spacer structures comprise silicon and nitrogen and the first and second dielectric spacers comprise silicon and oxygen.

Example 20 includes the electronic device of any one of Examples 15-19, wherein the one or more semiconductor nanoribbons comprise germanium, silicon, or a combination thereof.

Example 21 includes the electronic device of any one of Examples 15-20, wherein the first and second dielectric spacers protrude beyond the first and second ends, respectively, of the semiconductor nanoribbons by between about 1 nm and about 4 nm.

Example 22 includes the electronic device of any one of Examples 15-21, wherein the first and second source or drain regions are p-type source or drain regions.

Example 23 includes the electronic device of any one of Examples 15-22, further comprising a printed circuit board, wherein the chip package is coupled to the printed circuit board.

Example 24 is a method of forming an integrated circuit. The method includes forming a fin comprising layers of first semiconductor material alternating with layers of second semiconductor material, the fin extending above a substrate and extending lengthwise along a first direction; forming a sacrificial gate extending over the fin along a second direction and forming spacer structures on sidewalls of the sacrificial gate; removing a portion of the fin not protected by the sacrificial gate and sidewall structures such that ends of the layers of first semiconductor material alternating with layers of second semiconductor material are exposed; forming a source or drain region at the exposed ends of the layers of first semiconductor material and layers of second semiconductor material; removing the sacrificial gate; removing the layers of second semiconductor material thus exposing portions of the source or drain region; etching the exposed portions of the source or drain region to form lateral cavities; forming a dielectric material within the lateral cavities and adjacent to the ends of the layers of first semiconductor material; and forming a gate structure around the layers of first semiconductor material and on the dielectric material.

Example 25 includes the method of Example 24, wherein the layers of second semiconductor material has a semiconductor material that is different than the layers of first semiconductor material.

Example 26 includes the method of Example 24 or 25, wherein the layers of first semiconductor material comprise silicon and the layers of second semiconductor material comprise silicon and germanium.

Example 27 includes the method of any one of Examples 24-26, wherein the source or drain region comprises silicon and germanium.

Example 28 includes the method of any one of Examples 24-27, wherein the dielectric material comprises a low-k dielectric material.

Example 29 includes the method of Example 28, wherein the dielectric material comprises silicon and oxygen.

Example 30 includes the method of any one of Examples 24-29, wherein forming the dielectric material comprises epitaxially growing the dielectric material on the source or drain region.

Example 31 includes the method of any one of Examples 24-29, wherein forming the dielectric material comprises depositing the dielectric material using atomic layer deposition (ALD).

Example 32 is an integrated circuit that includes a first semiconductor device having one or more first semiconductor bodies (e.g., nanoribbons) extending in a first direction from a first source or drain region and a first gate structure extending in a second direction over the one or more first semiconductor bodies, a second semiconductor device having one or more second semiconductor bodies (e.g., nanoribbons) extending in the first direction from a second source or drain region and a second gate structure extending in the second direction over the one or more second semiconductor bodies, first dielectric spacers adjacent to ends of the first semiconductor bodies, and second dielectric spacers adjacent to ends of the second semiconductor bodies. The first dielectric spacers are between the first gate structure and the first source or drain region along the first direction and the second dielectric spacers are between the second gate structure and the second source or drain region along the second direction. The first dielectric spacers laterally protrude beyond the ends of the first semiconductor bodies along the first direction.

Example 33 includes the integrated circuit of Example 32, wherein the second direction is substantially orthogonal to the first direction, and the first dielectric spacers are aligned over one another along a third direction substantially orthogonal to the first and second directions, and the second dielectric spacers are aligned over one another along the third direction.

Example 34 includes the integrated circuit of Example 32 or 33, further comprising first spacer structures on sidewalls of at least a top portion of the first gate structure and second spacer structures on sidewalls of at least a top portion of the second gate structure.

Example 35 includes the integrated circuit of Example 34, wherein the first and second spacer structures comprise a dielectric material with a higher dielectric constant compared to the dielectric material of the first and second dielectric spacers.

Example 36 includes the integrated circuit of Example 35, wherein the first and second spacer structures comprise silicon and nitrogen and the first and second dielectric spacers comprise silicon and oxygen.

Example 37 includes the integrated circuit of any one of Examples 32-36, wherein the one or more first semiconductor bodies and one or more second semiconductor bodies comprise germanium, silicon, or a combination thereof.

Example 38 includes the integrated circuit of any one of Examples 32-37, wherein the first dielectric spacers protrude beyond the ends of the first semiconductor bodies by between about 1 nm and about 4 nm.

Example 39 includes the integrated circuit of any one of Examples 32-38, wherein the first source or drain region is a p-type source or drain region and the second source or drain region is an n-type source or drain region.

Example 40 includes the integrated circuit of any one of Examples 32-39, wherein the second dielectric spacers do not laterally protrude beyond the ends of the second semiconductor bodies along the first direction.

Example 41 is a die that includes the integrated circuit of any one of Examples 32-40.

The foregoing description of the embodiments of the disclosure has been presented for the purposes of illustration and description. It is not intended to be exhaustive or to limit the disclosure to the precise forms disclosed. Many modifications and variations will be apparent in light of this disclosure. It is intended that the scope of the disclosure be limited not by this detailed description, but rather by the claims appended hereto.

## Claims

1. An integrated circuit comprising:
a semiconductor device having one or more semiconductor bodies extending in a first direction from a source or drain region, and a gate structure extending in a second direction over the one or more semiconductor bodies; and
dielectric spacers adjacent to ends of the semiconductor bodies, such that the dielectric spacers are between the gate structure and the source or drain region along the first direction, wherein the dielectric spacers laterally protrude beyond the ends of the semiconductor bodies along the first direction.

2. The integrated circuit of claim 1, wherein the second direction is substantially orthogonal to the first direction, and the dielectric spacers are aligned over one another along a third direction substantially orthogonal to the first and second directions.

3. The integrated circuit of claim 1 or 2, further comprising spacer structures on sidewalls of at least a top portion of the gate structure.

4. The integrated circuit of claim 3, wherein the spacer structures comprise a dielectric material with a higher dielectric constant compared to the dielectric material of the dielectric spacers.

5. The integrated circuit of claim 4, wherein the spacer structures comprise silicon and nitrogen and the dielectric spacers comprise silicon and oxygen.

6. The integrated circuit of any one of claims 1 through 5, wherein the one or more semiconductor bodies comprise one or more nanoribbons or nanosheets.

7. The integrated circuit of any one of claims 1 through 6, wherein the dielectric spacers protrude beyond the ends of the semiconductor bodies by between about 1 nm and about 4 nm.

8. The integrated circuit of any one of claims 1 through 7, wherein the dielectric spacers extend into the source or drain region by about 1 nm and about 4 nm.

9. The integrated circuit of any one of claims 1 through 8, wherein the dielectric spacers each has a faceted end that extends into the source or drain region.

10. The integrated circuit of any one of claims 1 through 8, wherein the dielectric spacers each has a rounded end that extends into the source or drain region.

11. The integrated circuit of any one of claims 1 through 10, comprising an upper gate spacer above the dielectric spacers and having an innermost surface contacting a sidewall of the gate structure, wherein the dielectric spacers each has an end that extends laterally into the source or drain region, such that the ends of the dielectric spacers are laterally inward of, and not collinear with, the innermost surface of the upper gate spacer.

12. The integrated circuit of any one of claims 1 through 11, wherein the source or drain region is a p-type source or drain region.

13. A die comprising the integrated circuit of any one of claims 1 through 12.

14. A method of forming an integrated circuit, the method comprising:
forming a fin comprising layers of first semiconductor material alternating with layers of second semiconductor material, the fin extending above a substrate and extending lengthwise along a first direction;
forming a sacrificial gate extending over the fin along a second direction and forming spacer structures on sidewalls of the sacrificial gate;
removing a portion of the fin not protected by the sacrificial gate and sidewall structures such that ends of the layers of first semiconductor material alternating with layers of second semiconductor material are exposed;
forming a source or drain region at the exposed ends of the layers of first semiconductor material and layers of second semiconductor material;
removing the sacrificial gate;
removing the layers of second semiconductor material thus exposing portions of the source or drain region;
etching the exposed portions of the source or drain region to form lateral cavities;
forming a dielectric material within the lateral cavities and adjacent to the ends of the layers of first semiconductor material; and
forming a gate structure around the layers of first semiconductor material and on the dielectric material.

15. The method of claim 14, wherein: the layers of second semiconductor material has a semiconductor material that is different than the layers of first semiconductor material; the layers of first semiconductor material comprise silicon and the layers of second semiconductor material comprise silicon and germanium; the source or drain region comprises silicon and germanium; and/or the dielectric material comprises a low-k dielectric material.
